# EUROPÄISCHE PATENTANMELDUNG

(11) **EP 0 827 105 A2**
(43) Veröffentlichungstag der Anmeldung: **04.03.1998**
(21) Anmeldenummer: 97112884.8
(22) Anmeldetag: 25.07.1997
(51) Int. Cl.: G06K 13/07

(54) **Mit akustischen Oberflächenwellen arbeitende Identifizierungs- oder Sensoranordnung - OFW-Anordnung**

(30) Priorität: 29.08.1996 DE 19634978
(71) Anmelder: SIEMENS AKTIENGESELLSCHAFT, 80333 München (DE)
(72) Erfinder: Reindl, Leonhard, 83071 Stephanskirchen (DE); Ostertag, Thomas, 85464 Freising (DE); Ruile, Werner, 80636 München (DE)

(57) **Zusammenfassung**

OFW-ID-Tag oder Sensoranordnung für Informationssysteme, bei dem akusto-elektrisch aktive Komponenten (2, 3) auf einem piezoelektrischen Substrat(1) in unterschiedlichen akustischen Spuren angeordnet sind und zu deren akustischer Kopplung ein Umlenker (4) vorgesehen ist.

## Beschreibung

Die vorliegende Erfindung betrifft eine mit akustischen Oberflächenwellen arbeitende Identifizierungs- oder Sensoranordnung - OFW-Anordnung - dem Oberbegriff des Patentanspruchs 1.

Identifizierungsmarken -im folgenden kurz ID-Tag genanntsind Identifizierungsanordnungen der gattungsgemäßen Art und werden in Identifizierungssystemen zur berührungslosen automatischen Identifikation von Objekten verwendet; sie sind beispielsweise aus der DE-OS 44 05 647 bekannt. Derartige ID-Tags sind Bauelemente, in denen ein elektrisches Signal mittels eines Wandlers in eine akustische Oberflächenwelle umgesetzt wird, welche an einer Folge von Reflektoren reflektiert wird, wobei die reflektierte akustische Oberflächenwelle durch einen Wandler, welcher gleich dem das elektrische Eingangssignal umsetzenden Wandler sein kann, wieder in ein elektrisches Signal umgesetzt wird. In Abhängigkeit von der Konfiguration der Reflektoren entsteht ein vorgegebener Code, welcher dieses ID-Tag repräsentiert. Das den Code repräsentierende elektrische Signal wird auf ein das Abfragesignal aussendendes System zurückgesendet, wodurch die Stelle identifizierbar ist, an der das ID-Tag angeordnet ist. Derartige Identifizierungssysteme sind in einer großen Vielzahl von Anwendungsfallen verwendbar.

Wie vorstehend ausgeführt, wird der Informationsinhalt des vom ID-Tag kommenden Antwortsignals durch die Konfiguration der in ihm enthaltenden Reflektoren bestimmt. Die Information kann beispielsweise binär dadurch festgelegt sein, daß für eine vorgegebene Anzahl von Information-Bits eine Reflektorkonfiguration vorgesehen ist, bei der einem vorhandenen Reflektor ein 1-Bit und einem befehlenden Reflektor ein 0-Bit entspricht, d.h. an einem vorhandenen Reflektor erfolgt eine Rückreflexion auf den Ausgangswandler, während bei einem befehlenden Reflektor kein durch Reflexion entstehendes Bit vorhanden ist. Eine derartige Kodierung entspricht einer Amplitudenmodulation.

Der Informationsinhalt kann auch einer Phasenmodulation entsprechen, wenn in einer Folge von Reflektoren die einzelnen Reflektoren aus einer vorgegebenen, einer 0-Phasenlage entsprechenden Position verschoben werden.

Beispielsweise aus der EP-PS 0 619 906 bekannte drahtlos abfragbare OFW-Sensoren sind Sensoranordnungen der gattungsgemäßen Art. Sie enthalten erste OFW-Strukturen als Sensorelemente und zweite OFW-Strukturen als Referenzelemente, wobei Meßwerte abfragbar sind, sie aus einem Vergleich der sich aus Abfragesignalen ergebenden Ausgangssignale der Sensor- und Referenzelemente gebildet werden.

Anordnungen der vorstehend erläuterten Art müssen konstruktiv jedoch so ausgebildet sein, daß Impulse im Antwort- oder Meßsignal, sicher trennbar sind, damit eine sichere Auflösung der Information im Antwortsignal möglich ist. Da der auflösbare zeitliche Impuls- bzw. Bitabstand umgekehrt proportional zur Bandbreite ist, ergibt sich bei einer kleinen zur Verfügung stehenden Bandbreite des Abfragesignals ein großer zeitlicher Bitabstand, woraus wiederum folgt, daß der Abstand von OFW-Strukturen in Identifizierungs- oder Sensoranordnungen entsprechend groß sein muß. Dies bedeutet insbesondere dann, wenn die OFW-Strukturen in einer einzigen akustischen Spur angeordnet sind, daß ein entsprechend langes piezoelektrisches Substrat für die Anordnung erforderlich ist. Dies hat wiederum einen großen baulichen Aufwand speziell für OFW-Anordnungsgehäuse zur Folge.

Der vorliegenden Erfindung liegt daher die Aufgabe zugrunde, eine wenig aufwendige und daher kostengünstige Anordnung der in Rede stehenden Art anzugeben.

Diese Aufgabe wird bei einer OFW-Anordnung der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird nachfolgend anhand von Ausführungsbeispielen gemäß den Figuren der Zeichnung näher erläutert.

Es zeigt:
- Figur 1: eine schematische Darstellung einer erfindungsgemäßen Anordnung in Form eines OFW-ID-Tags;
- Figur 2: eine Ausführungsform eines Interdigitalwandlers in Form eines sogenannten SPUDT's für ein ID-Tag nach Figur 1;
- Figur 3: eine erste Ausführungsform eines im ID-Tag nach Figur 1 verwendbaren Umlenkers;
- Figur 4: eine zweite Ausführungsform eines im ID-Tag nach Figur 1 verwendbaren Umlenkers;
- Figur 5: eine schematische Darstellung eines Gehäuseteils für die akustisch aktiven Teile eines ID-Tags nach Figur 1;
- Figur 6: eine schematische Darstellung eines geschlossenen Gehäuses entsprechend Figur 5 für die akustisch aktiven Teile des ID-Tags nach Figur 1;
- Figur 7: eine schematische perspektivische Darstellung eines mit einem Gehäuse nach den Figuren 5 und 6 versehenen ID-Tags nach Figur 1;
- Figur 8: eine schematische perspektivische Darstellung eines in eine Chip-Karte integrierten ID-Tags; und
- Figur 9: einen Ausschnitt des ID-Tags nach Figur 1.

Es sei zunächst darauf hingewiesen, daß sich die nachfolgenden Erläuterungen auf Ausführungsformen von ID-Tags beziehen. Sie gelten jedoch in für den Fachmann ersichtlicher Weise auch für Sensoranordnungen etwa gemäß der oben genannten EP-PS 0 619 906.

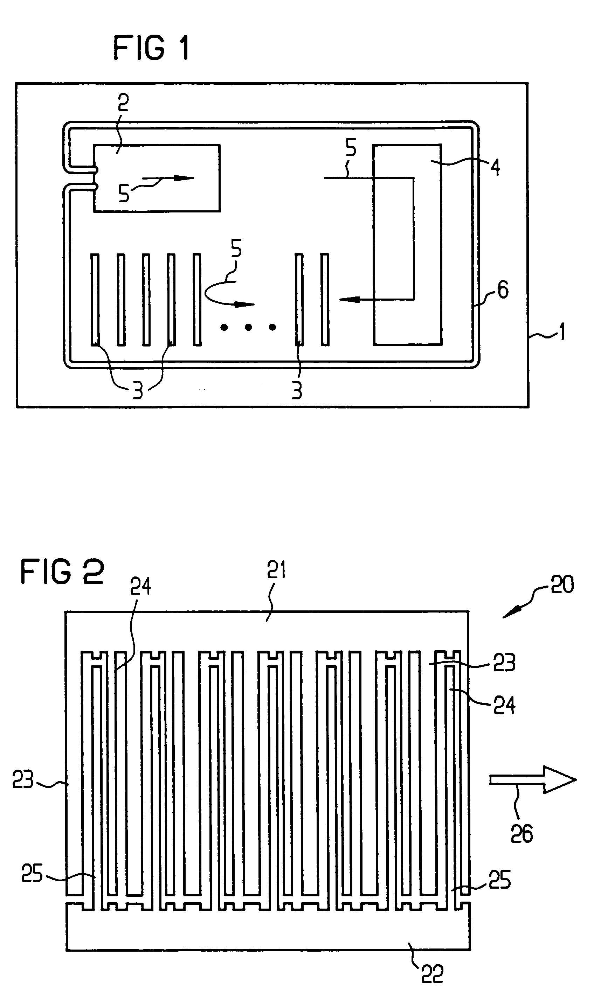

Gemäß der schematischen Darstellung nach Figur 1 sind in einem ID-Tag in an sich bekannter Weise auf einem piezoelektrischen Substrat 1 ein Interdigitalwandler 2, der hier als Eingangs/Ausgangswandler wirkt, sowie Reflektoren 3 vorgesehen. Wie eingangs ausgeführt, wird im Interdigitalwandler 2 ein elektrisches Abfragesignal in eine akustische Welle umgesetzt, die an den Reflektoren 3 reflektiert und im Interdigitalwandler 2 wiederum in ein elektrisches Antwortsignal umgesetzt wird.

Erfindungsgemäß sind jedoch der Interdigitalwandler 2 und die Reflektoren 3 nicht in einer oder mehreren parallelen akustischen Spuren hintereinander sondern in unterschiedlichen akustisch in Serie geschalteten Spuren angeordnet, um die vom Interdigitalwandler 2 ausgehende akustische Welle auf die Reflektoren 3 zu führen, ist ein Umlenker 4 vorgesehen, der wiederum die von den Reflektoren 3 reflektierten Wellenanteile auf den Interdigitalwandler 2 zurückführt. Der Verlauf der akustischen Wellenanteile ist in Figur 1 durch Pfeile 5 angedeutet.

Die vorstehend erläuterte erfindungsgemäße Ausbildung eines ID-Tag besitzt den Vorteil, daß durch die Anordnung von Interdigitalwandler 2 und Reflektoren 3 in mehreren in Serie geschalteten akustischen Spuren der akustische Weg mehrmals gefaltet werden kann. Die Vergrößerung der Substratabmessung in Richtung senkrecht zur Ausbreitung der akustischen Wellenanteile wird durch Längenreduzierung in Richtung der Ausbreitung der akustischen Wellenanteile weit überkompensiert, da die akustische Spur üblicherweise wesentlich schneller als die Substratbreite ist. Zudem kann dadurch eine Substratform realisiert werden, die für eine Gehäusetechnik oder ein Einfügen in eine Chipkarte en deutlich günstigeres Längen-zuBreitenverhältnis aufweist.

In Weiterbildung der Erfindung ist gemäß Figur 1 auf dem Substrat 1 eine Struktur 6 zur Einkopplung eines elektrischen Abfragesignals in den Interdigitalwandler 2 vorgesehen, welche bei dieser Ausführungsform als induktive rahmenförmige Koppelschleife ausgebildet ist. Anstelle einer derartig induktiv koppelnden Antenne kann auch eine kapazitiv koppelnde Struktur gemäß Figur 9 vorgesehen sein, welche einen Ausschnitt aus Figur 1 darstellt. Dazu können auf dem Substrat 1 zwei flächige Koppelpads 91, 92 -Metallisierungen- Verwendung finden, die elektrisch an den Interdigitalwandler 2 angekoppelt sind.

Eine niedrigere Einführungsdämpfung des ID-Tags und damit eine höhere Reichweite eines Identifizierungssystems ist durch Verwendung eines Einphasen-Unidirektionalwandlers (Single Phase Unidirectional Transducer-SPUDT) realisierbar. Ein derartiger Unidirektionalwandler besitzt mittels zweier Sammelschienen 21, 22 verbundene Elektrodenfinger 23, 24, 25 wobei jeweils zwei Elektrodenfinger 23, 24 unterschiedlicher Breite an der Sammelschiene 21 mit einem Elektrodenfinger 25 an der Sammelschiene 22 verschachtelt sind. Die Abstrahlungsrichtung der akustischen Welle ist durch einen Pfeil 26 angedeutet. Mit einem derartigen Unidirektionalwandler läßt sich eine Verringerung der Einfügungsdämpfung um 3dB beim Ein- und Auskoppeln, d.h. insgesamt um 6dB erreichen. Die maximale Reichweite eines Identifizierungssystems mit einem einen derartigen Unidirektionalwandler enthaltenden ID-Tag wird um den Faktor Wurzel 2 erhöht.

Figur 2 zeigt eine erste Ausführungsform des Umlenkers 4 nach Figur 1 in Form eines Reflektormultistripkopplers 30. Ein derartiger Reflektormultistripkoppler wird durch zwei durch eine Elektrodenverbindung 33 miteinander verbundene Sammelschienen 31 und 32 gebildet, an denen jeweils Elektrodenfinger 34, 35 angeschlossen sind. Zwischen diesen angeschlossenen Elektrodenfingern 34, 35 sind jeweils nicht angeschlossene Elektrodenfingerpaare 36, 37 angeordnet. Die Breite von zwei durch einen derartigen Reflektormultistripkoppler 30 gebildeten akustischen Spuren ist mit W bezeichnet, während die beiden gegenläufigen Ausbreitungsrichtungen einer akustischen Wellen mit A bzw. B bezeichnet sind.

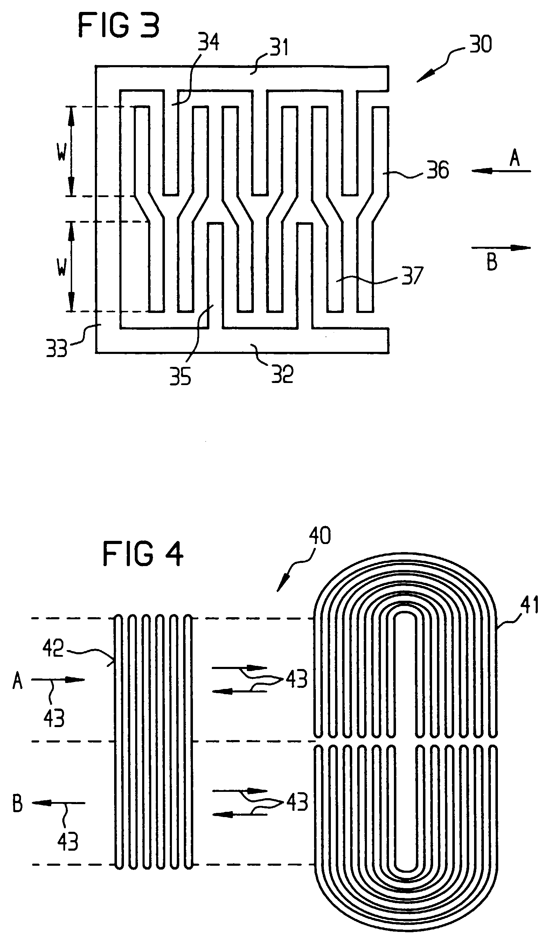

Eine weitere Ausführungsform eines Umlenkers ist in Figur 4 dargestellt und generell mit 40 bezeichnet. Diese Umlenker wird durch einen eine arenaförmige Struktur besitzenden Multistripreflektor 41 sowie einen Multistripkoppler 42 gebildet. Die Ausbreitungsrichtungen von akustischen Wellen sind dabei durch Pfeile 43 angedeutet, während zwei akustische Spuren mit A bzw. B bezeichnet sind.

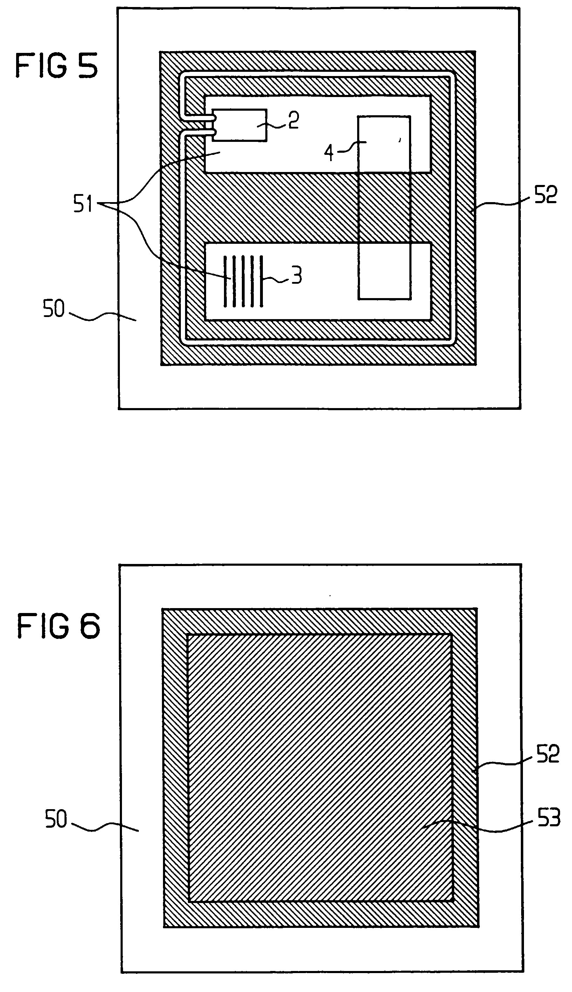

Die Figuren 5 bis 7 zeigen eine mögliche Ausführungsform eines Gehäuses für ein erfindungsgemäßes ID-Tag, das wenigstens die akusto-elektrischen Komponenten abdeckt, wobei das piezoelektrische Substrat des ID-Tags als Gehäuseteil angesehen werden kann.

Gemäß Figur 5 wird auf ein piezoelektrisches Substrat 5 eine fotolithographisch strukturierbare Folie auflaminiert, die strukturiert wird, daß nur auf akustisch nicht aktiven Bereichen des Substrats 50 eine Rahmenfolie 52 stehen bleibt, während akusto-elektrische Komponenten in Bereichen 51 frei von der Rahmenfolie 52 bleiben. Eine Ausnahme kann darin bestehen, daß der Umlenker 4 in seinem mittleren Bereich bedeckt bleibt, wodurch die konstruktive Stabilität erhöht und gleichzeitig ein akustisches Übersprechen durch Beugung zwischen den akustischen Spuren eliminiert werden kann.

Gemäß Figur 6 wird anschließend auf die Anordnung nach Figur 5 eine weitere Folie derart auflaminiert, daß sich eine Deckfolie 53 ergibt, wodurch über den akusto-elektrischen Komponenten ein Mikrohohlraum entsteht, der die Akustik schützt.

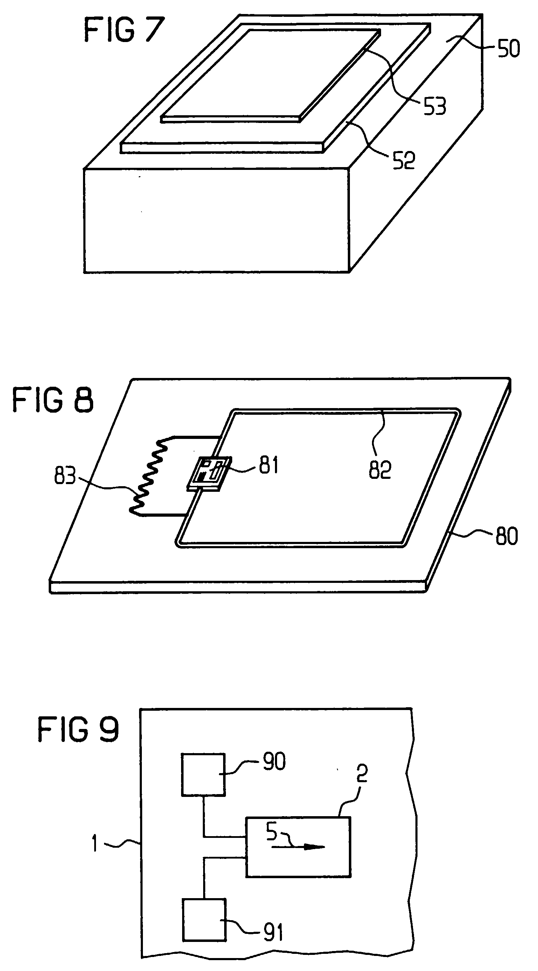

In Figur 7 ist eine derartige Anordnung schematisch perspektivisch dargestellt.

Gehäuse für erfindungsgemäße Anordnungen sind nicht auf die vorstehend erläuterte Bauform beschränkt.

So kann beispielsweise ein Gehäuseabschluß durch einen für eine Aufnahme der akusto-elektrisch aktiven Komponenten der Anordnung strukturierten Deckel gebildet werden. Der Deckel kann durch Kleben, Glaslot und direkt durch Waferbonding mit dem piezoelektrischen Substrat verbunden werden.

Weiterhin kann z. B. auch ein die akusto-elektrisch aktiven Komponenten der Anordnung umgebendes Glasgitter auf das piezoelektrische Substrat aufgebracht werden, auf dem ein Deckel in geeigneter Weise befestigt wird.

Figur 8 zeigt schematisch eine Möglichkeit, wie ein erfindungsgemäßes ID-Tag der oben beschriebenen Art in eine Chip-Karte integriert werden kann. Das in Figur 8 mit 81 bezeichnete ID-Tag wird in geeigneter Weise auf eine Chip-Karte 80 aufgesetzt und seine Koppelstruktur 6 nach Figur 1 oder seine Koppelpads 91, 92 nach Figur 9 mit einer Kartenantenne 82 gekoppelt. Im Bedarfsfall kann bei einer induktiven Ankopplung der ID-Tag-Koppelstruktur an die Kartenantenne eine elektrische Anpassung vorgenommen werden. Eine derartige Anpassung ist in Figur 8 schematisch durch ein Anpassungselement 83 angedeutet. Es sei darüberhinaus darauf hingewiesen, daß die Kopplung nicht induktiv oder kapazitiv zu erfolgen braucht. Es kann auch eine galvanische Verbindung - Bondverbindung - erfolgen, wozu dann den Pads 91, 92 entsprechende Bondpads vorgesehen sind.

## Patentansprüche

1. Mit akustischen Oberflächenwellen arbeitende Identifizierungs- oder Sensoranordnung - OFW-Anordnung - für Identifizierungs- oder Sensorsysteme, in denen ein Abfrage/Auswertegerät Identifizierungs- oder Sensoranordnungen mittels eines drahtlos übertragenen Abfragesignals abfragt und ein von diesen rückgesendetes Antwortsignal auswertet, mit akusto-elektrisch aktiven Komponenten (2, 3; 20, 3) auf einem piezoelektrischen Substrat (1; 50),
**dadurch gekennzeichnet,** daß die akusto-elektrisch wirksamen Komponenten (2, 3; 20, 3) in unterschiedlichen akustischen Spuren auf dem Substrat (1; 50) angeordnet sind und daß zu deren akustischer Kopplung ein Umlenker (4; 30; 40) vorgesehen ist.

2. Anordnung nach Anspruch 1 in Form einer Identifizierungsmarke - OFW-ID-Tag mit mindestens einem Interdigitalwandler (2; 20) und einer vorgegebenen Anzahl von Reflektoren (3), wobei in einem Identifizierungssystem eine Kodierung durch die Anzahl und die Lage der Reflektoren (3) gegeben ist,
**dadurch gekennzeichnet,**
daß der Interdigitalwandler (2; 20) und wenigstens ein Teil der Reflektoren (3) in unterschiedlichen akustischen Spuren angeordnet sind und zur akustischen Kopplung der Spuren ein Umlenker (4; 30; 40) vorgesehen ist.

3. Anordnung nach Anspruch 2,
**dadurch gekennzeichnet,** daß als Interdigitalwandler (20) ein Unidirektionalwandler vorgesehen ist.

4. Anordnung nach einem der Ansprüche 1 bis 3,
**dadurch gekennzeichnet,** daß der Umlenker durch einen Reflektormultistripkoppler (30) gebildet ist.

5. Anordnung nach einem der Ansprüche 1 bis 3,
**dadurch gekennzeichnet,** daß der Umlenker (40) durch einen Multistripkoppler (42) und einen Multistripreflektor (41) gebildet ist.

6. Anordnung nach einem der Ansprüche 1 bis 5,
**dadurch gekennzeichnet,** daß die Reflektoren (3) in einer einzigen akustischen Spur angeordnet sind.

7. Anordnung nach einem der Ansprüche 1 bis 6,
**dadurch gekennzeichnet,** daß die Reflektoren (3) zur Kodierung des Antwortsignals geometrisch so aus einer vorgegebenen 0-Phasenlage verschoben sind, daß sich eine Phasenmodulationskodierung des Antwortsignals ergibt.

8. Anordnung nach einem der Ansprüche 1 bis 7,
**dadurch gekennzeichnet,** daß eine das Abfragesignal einkoppelnde Struktur (6; 90, 91)) auf dem Substrat vorgesehen ist.

9. Anordnung nach Anspruch 8,
**dadurch gekennzeichnet,** daß die Struktur (6) als rahmenförmige Koppelschleife zur induktiven Einkopplung des Abfragesignals ausgebildet ist.

10. Anordnung nach Anspruch 8,
**dadurch gekennzeichnet,** daß die Struktur (90, 91) durch Koppelpads zur kapazitiven oder galvanischen Einkopplung des Abfragesignals gebildet ist.

11. Anordnung nach einem der Ansprüche 1 bis 10,
**gekennzeichnet durch** wenigstens die akustoelektrischen Komponenten (2, 3, 4) enthaltendes auf dem piezoelektrischen Substrat (50) vorgesehenes Gehäuse (52, 53).

12. Anordnung nach Anspruch 11,
**dadurch gekennzeichnet,** daß das Gehäuse (52, 53) durch eine die elektro-akustischen Komponenten (2, 3, 4) umgebende Rahmenfolie (52) sowie eine auf der Rahmenfolie (52) befindliche Deckfolie (53) gebildet ist.

13. Verwendung einer Identifizierungsmarke nach einem der Ansprüche 2 bis 12 in einer Chip-Karte,
**dadurch gekennzeichnet,** daß die Identifizierungsmarke (81) derart in die eine Karten-Antenne (82) aufweisende Karte (80) integriert ist, daß die Identifizierungsmarken-Koppelstruktur (6; 90, 91) an die Kartenantenne (82) angekoppelt ist.
